# EUROPÄISCHE PATENTSCHRIFT

(11) **EP 2 054 947 B1**
(45) Veröffentlichungstag und Bekanntmachung des Hinweises auf die Patenterteilung: **22.02.2017**
(21) Anmeldenummer: 07801339.8
(22) Anmeldetag: 14.09.2007
(51) Int. Cl.: H01L 33/48, H05K 1/02, H05K 1/05

(54) **OPTOELEKTRONISCHES BAUELEMENT**
OPTOELECTRONIC COMPONENT
COMPOSANT OPTO-ÉLECTRONIQUE

(30) Priorität: 29.09.2006 DE 102006046304; 18.12.2006 DE 102006059702
(43) Veröffentlichungstag der Anmeldung: 06.05.2009
(73) Patentinhaber: OSRAM Opto Semiconductors GmbH, 93055 Regensburg (DE)
(72) Erfinder: GRÖTSCH, Stefan, 93077 Lengfeld-Bad Abbach (DE); WINTER, Kristin, 112 Taipei Taiwan (HK)
(74) Vertreter: Epping - Hermann - Fischer
(86) Internationale Anmeldenummer: PCT/DE2007/001672
(87) Internationale Veröffentlichungsnummer: WO 2008/040296

(56) Entgegenhaltungen:
- WO-A-2006/013503
- JP-A- 4 105 350
- US-A1- 2006 067 373
- US-B1- 6 498 355

## Beschreibung

Die Erfindung betrifft ein optoelektronisches Bauelement gemäß dem Oberbegriff des Patentanspruchs 1.

Bei optoelektronischen Bauelementen, die einen oder mehrere strahlungsemittierende Halbleiterchips enthalten, die aufgrund ihrer hohen Leistung eine große Menge an Wärme erzeugen, werden die Halbleiterchips oftmals auf einen Chipträger mit einer guten Wärmeleitfähigkeit montiert, insbesondere auf einen Chipträger aus einer Keramik. Zur elektrischen Kontaktierung des optoelektronischen Bauelements wird der Chipträger in der Regel auf eine Leiterplatte, die Leiterbahnen aufweist, montiert.

Die Leiterplatte kann insbesondere eine Metallkernplatine sein, die einen Metallkern, beispielsweise aus Aluminium oder Kupfer, eine auf den Metallkern aufgebrachte dielektrische Schicht und eine auf der dielektrischen Schicht aufgebrachte elektrisch leitfähige Schicht, beispielsweise aus Kupfer, aufweist. Aufgrund des Metallkerns hat die Metallkernplatine eine vergleichsweise hohe Wärmeleitfähigkeit. Dokument US 6,498,355 B1 offenbart ein optoelektronisches Bauelement mit einer Metallkernplatine gemäß der Einleitung des Anspruchs 1.

Allerdings ist bei der Verwendung eines Chipträgers, beispielsweise aus einer Keramik, die thermische Anbindung des Chipträgers an die Metallkernplatine oftmals nicht zufriedenstellend, sodass die von den Chips erzeugte Wärme nur unzureichend an die Metallkernplatine abgeführt wird.

Der Erfindung liegt die Aufgabe zugrunde, ein verbessertes optoelektronisches Bauelement mit einem auf einer Metallkernplatine angeordneten Chipträger anzugeben, das sich insbesondere durch eine verbesserte Wärmeabfuhr von dem Chipträger zur Metallkernplatine auszeichnet.

Diese Aufgabe wird durch ein optoelektronisches Bauelement mit den Merkmalen des Patentanspruchs 1 gelöst. Vorteilhafte Ausgestaltungen und Weiterbildungen der Erfindung sind Gegenstand der abhängigen Ansprüche.

Ein optoelektronisches Bauelement gemäß der Erfindung enthält eine Metallkernplatine, die einen Metallkern, eine auf den Metallkern aufgebrachte dielektrische Schicht und eine auf die dielektrische Schicht aufgebrachte elektrisch leitfähige Schicht aufweist. Weiterhin enthält das optoelektronische Bauelement einen Chipträger, der mit der Metallkernplatine verbunden ist, wobei der Chipträger eine erste Hauptfläche und eine zweite, der Metallkernplatine zugewandte zweite Hauptfläche aufweist. Auf der ersten Hauptfläche sind mindestens ein optoelektronischer Halbleiterchip oder vorzugsweise mehrere optoelektronische Halbleiterchips angeordnet.

Der Chipträger ist an der zweiten Hauptfläche mittels einer Lötverbindung mit dem Metallkern der Metallkernplatine verbunden, wobei die dielektrische Schicht und die elektrisch leitfähige Schicht im Bereich der Lötverbindung von dem Metallkern entfernt sind.

Der Chipträger ist also mittels einer Lötverbindung direkt mit dem Metallkern der Metallkernplatine verbunden. Die Verbindung zwischen dem Chipträger und dem Metallkern der Metallkernplatine zeichnet sich dabei durch eine vorteilhaft hohe Wärmeleitfähigkeit aus. Vorteilhaft sind zwischen dem Chipträger und dem Metallkern keine Schichten mit einer vergleichsweise geringen Wärmeleitfähigkeit enthalten, da insbesondere die dielektrische Schicht in dem Bereich der Lötverbindung vom dem Metallkern entfernt ist. Die dielektrische Schicht und die elektrisch leitfähige Schicht können beispielsweise in dem zur Herstellung der Lötverbindung vorgesehenen Bereich durch Fräsen oder durch eine Laserbearbeitung von dem Metallkern entfernt werden. Die dielektrische Schicht und/oder die Metallschicht können alternativ auch schon vor dem Aufbringen auf den Metallkern strukturiert werden, beispielsweise durch Stanzen einer dünnen Folie.

Mittels der thermisch leitenden Lötverbindung zwischen dem Chipträger und dem Metallkern wird die von dem mindestens einem optoelektronischen Halbleiterchip erzeugte Wärme effizient an den Metallkern der Metallkernplatine abgeführt.

Bei einer bevorzugten Ausführungsform weist der Chipträger an der zweiten Hauptfläche in dem Bereich, in dem die Lötverbindung zum Metallkern der Metallkernplatine ausgebildet ist, eine der Metallkernplatine zugewandte Erhöhung auf. Der Chipträger ist also an der zweiten Hauptfläche in dem Bereich der Lötverbindung gegenüber anderen Teilbereichen, insbesondere gegenüber Teilbereichen, in denen elektrische Kontakte zur Kontaktierung der Halbleiterchips angeordnet sind, erhöht.

Bei einer weiteren bevorzugten Ausführungsform weist der Metallkern der Metallkernplatine in dem Bereich der Lötverbindung eine dem Chipträger zugewandte Erhöhung auf.

Durch die Erhöhung wird ein Abstand zwischen dem Metallkern der Metallkernplatine und dem Chipträger im Bereich der Lötverbindung vorteilhaft vermindert. Der Abstand zwischen dem Metallkern und dem Chipträger ist beispielsweise dadurch vorgegeben, dass der Chipträger an der zweiten Hauptfläche mittels weiterer Lötverbindungen mit der elektrisch leitfähigen Schicht der Metallkernplatine verbunden ist. In diesem Fall ist der Abstand zwischen dem Metallkern und der zweiten Hauptfläche des Chipträgers gleich der Summe der Dicken der dielektrischen Schicht, der elektrisch leitfähigen Schicht und der zur Herstellung der elektrischen Verbindungen vorgesehenen Lötverbindung.

Vorteilhaft stimmt die Höhe der Erhöhung im Wesentlich mit einer Summe der Dicken der auf die Metallkernplatine aufgebrachten dielektrischen Schicht und der auf der dielektrischen Schicht aufgebrachten elektrisch leitfähigen Schicht überein oder ist vorzugsweise sogar gleich der Summe der Dicken dielektrischen Schicht und der elektrisch leitfähigen Schicht. Der aufgrund des Entfernens der dielektrischen Schicht und der elektrisch leitfähigen Schicht von dem Metallkern der Metallkernplatine bedingte zusätzliche Abstand des Chipträgers von der Metallkernplatine in dem Bereich der Lötverbindung wird also durch die Erhöhung des Chipträgers oder des Metallkerns in diesem Bereich verringert oder vorzugsweise ganz kompensiert.

Dies hat den Vorteil, dass beispielsweise ein an der zweiten Hauptfläche angeordneter Kontakt des Chipträgers mit der elektrisch leitfähigen Schicht auf der Metallkernplatine mit einer etwa gleich dicken Lotschicht verbunden werden kann, wie sie zur Verbindung des Chipträgers mit dem Metallkern der Metallkernplatine zur Herstellung der thermisch leitenden Verbindung erforderlich ist. Somit kann die Lötverbindung zwischen dem Chipträger und dem Metallkern der Metallkernplatine dünner ausgeführt werden als im Falle eines Chipträgers oder eines Metallkerns ohne Erhöhung. Durch die vergleichsweise dünne Lotschicht wird der Wärmewiderstand der Verbindung zwischen dem Chipträger und dem Metallkern der Metallkernplatine weiter verringert.

Die Erhöhung weist vorzugsweise eine Höhe zwischen einschließlich 50 µm und einschließlich 200 µm, insbesondere zwischen einschließlich 50 µm und einschließlich 150 µm, auf.

Der Metallkern der Metallkernplatine weist vorzugsweise Kupfer auf. Ein Metallkern aus Kupfer ist insbesondere vorteilhaft, da Kupfer eine vergleichsweise hohe Wärmeleitfähigkeit aufweist. Alternativ kann der Metallkern der Metallkernplatine beispielsweise auch Aluminium enthalten, wenn dieses lötbar beschichtet ist.

Das Material des Chipträgers ist bevorzugt eine Keramik. Insbesondere kann die Keramik, aus der der Chipträger gefertigt ist, Aluminiumnitrid enthalten. Der Chipträger aus einer Keramik zeichnet sich somit vorteilhaft durch eine vergleichsweise hohe Wärmeleitfähigkeit aus. Die Keramik kann daher die von dem mindestens einen auf dem Chipträger angeordneten optoelektronischen Halbleiterchip erzeugte Wärme aufnehmen und über die Lötverbindung zu dem Metallkern der Metallkernplatine abführen.

Der Chipträger ist bevorzugt ein elektrisch isolierender Chipträger. Auf dem elektrisch isolierenden Chipträger können beispielsweise mehrere optoelektronische Halbleiterchips angeordnet sein, die durch elektrische Verbindungen in Serie geschaltet sind. Ein elektrisch isolierender Chipträger, insbesondere aus einer Keramik, hat den Vorteil, dass der mindestens eine optoelektronische Halbleiterchip mittels der Lötverbindung zwischen dem Chipträger und dem Metallkern elektrisch potentialfrei, aber thermisch leitend mit dem Metallkern der Metallkernplatine verbunden ist. Insbesondere können auch mehrere Chipträger mit jeweils einem oder mehreren optoelektronischen Halbleiterchips auf der Metallkernplatine angeordnet sein, wobei zwischen den Halbleiterchips und dem Metallkern der Metallkernplatine eine elektrisch potentialfreie thermische leitende Verbindung besteht.

Bei einer bevorzugten Ausführungsform weist der Chipträger an der zweiten Hauptfläche Kontakte zur elektrischen Kontaktierung des mindestens einen optoelektronischen Halbleiterchips auf. Die Kontakte sind mit der elektrisch leitfähigen Beschichtung der Metallkernplatine, die vorzugsweise zu Leiterbahnen strukturiert sind, verbunden. Die Kontakte weisen bevorzugt ein Dicke auf, die geringer als die Höhe der Erhöhung ist.

Bei einer weiteren bevorzugten Ausführungsform der Erfindung sind mehrere optoelektronische Halbleiterchips auf dem Chipträger angeordnet. In diesem Fall ist die mittels der Lötverbindung zwischen dem Chipträger und dem Metallkern der Metallkernplatine erzielte gute Wärmeableitung besonders vorteilhaft, insbesondere wenn es sich bei den mehreren optoelektronischen Halbleiterchips um Halbleiterchips mit einer hohen Ausgangsleistung handelt. Beispielsweise können vier oder sechs optoelektronische Halbleiterchips in einem Array auf dem Chipträger angeordnet sein.

Bei dem mindestens einen optoelektronischen Halbleiterchip kann es sich insbesondere um einen LED-Chip handeln. Vorzugsweise sind mehrere LED-Chips auf dem Chipträger angeordnet. Das optoelektronische Bauelement ist vorzugsweise ein LED-Mo-dul, das zu Beleuchtungszwecken eingesetzt wird. Insbesondere kann es einen oder mehrere Weißlicht emittierende LED-Chips enthalten.

Bei dem mindestens einen LED-Chip handelt es sich vorzugsweise um einen Hochleistungs-LED-Chip, der vorzugsweise eine Leistung von 0,2 W oder besonders bevorzugt von 0,5 W oder mehr aufweist.

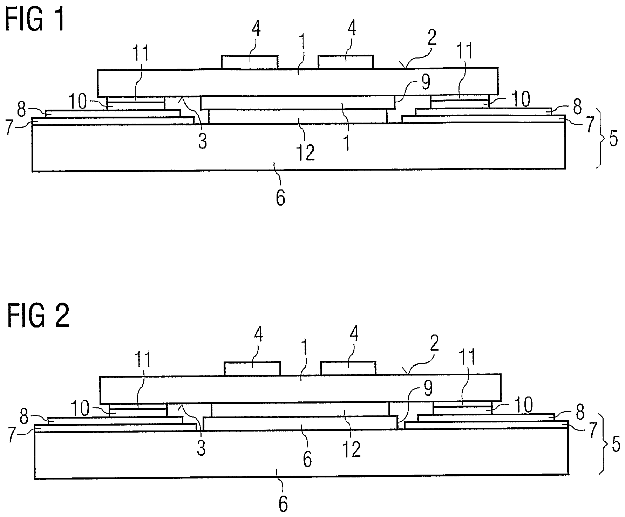

Die Erfindung wird im Folgenden anhand von zwei Ausführungsbeispielen im Zusammenhang mit den Figuren 1 und 2 näher erläutert.

Es zeigen:
- Figur 1: eine schematische grafische Darstellung eines Querschnitts durch ein optoelektronisches Bauelement gemäß einem ersten Ausführungsbeispiel der Erfindung, und
- Figur 2: eine schematische grafische Darstellung eines Querschnitts durch ein optoelektronisches Bauelement gemäß einem zweiten Ausführungsbeispiel der Erfindung.

Die Figuren sind nicht als maßstabsgerecht anzusehen, vielmehr können einzelne Elemente zur besseren Verdeutlichung übertrieben groß dargestellt sein.

Bei dem in Figur 1 dargestellten Ausführungsbeispiel eines optoelektronischen Bauelements gemäß der Erfindung handelt es sich um ein LED-Modul, bei dem mehrere LED-Chips 4 auf einem Chipträger 1 angeordnet sind. Bei den LED-Chips 4 handelt es sich vorzugsweise um Hochleistungs-LED-Chips. Diese können beispielsweise eine Ausgangsleistung von 0,2 W oder mehr, besonders bevorzugt von 0,5 W oder mehr, aufweisen. Alternativ kann es sich bei den optoelektronischen Halbleiterchips 4 auch um andere optoelektronische Halbleiterchips, wie beispielsweise Halbleiterlaser, handeln. Die Anzahl der LED-Chips 4 auf dem Chipträger 1 beträgt vorzugsweise zwischen einschließlich 4 und einschließlich 6, es können aber auch bis zu 10 oder sogar noch mehr LED-Chips 4 auf dem Chipträger 1 angeordnet sein.

Der Chipträger 1 weist eine den optoelektronischen Halbleiterchips 4 zugewandte erste Hauptfläche 2 und eine zweite Hauptfläche 3 auf, die einer Metallkernplatine 5 zugewandt ist. Die Metallkernplatine 5 fungiert als Träger für den Chipträger 1 und dient insbesondere zum Herstellen der elektrischen Anschlüsse für die auf dem Chipträger 1 angeordneten Halbleiterchips 4.

Die Metallkernplatine 5 weist einen Metallkern 6 auf. Der Metallkern 6 enthält vorzugsweise Kupfer, das sich durch eine gute Wärmeleitfähigkeit auszeichnet. Die Metallkernplatine 5 ist mit einer dielektrischen Schicht 7 versehen, die zur elektrischen Isolierung einer elektrisch leitfähigen Schicht 8, in der beispielsweise Leiterbahnen zur elektrischen Kontaktierung des optoelektronischen Bauelements ausgebildet sind, von dem Metallkern 6 dient.

Beispielsweise weist der Chipträger 1 an seiner der Metallkernplatine 5 zugewandten zweiten Hauptfläche 3 elektrische Kontakte 11 auf, die mittels Lötverbindungen 10 mit der elektrisch leitfähigen Schicht 8 auf der Metallkernplatine 5 elektrisch leitend verbunden sind. Die Kontakte 11 sind beispielsweise mit über den Chipträger 1 geführten Leiterbahnen mit elektrischen Kontakten der optoelektronischen Halbleiterchips verbunden (nicht dargestellt).

Der Chipträger 1 ist vorzugsweise aus einem Material mit einer guten Wärmeleitfähigkeit gefertigt. Insbesondere kann der Chipträger 1 eine Keramik, vorzugsweise Aluminiumnitrid, enthalten. Somit kann die von den optoelektronischen Halbleiterchips 4 erzeugte Wärme gut von dem Chipträger 1 aufgenommen werden.

Um die Wärme von dem Chipträger 1 abzuführen, ist der Chipträger 1 mittels einer Lötverbindung 12 mit dem Metallkern 6 der Metallkernplatine 5 verbunden. In dem Bereich der Lötverbindung 12 sind die dielektrische Schicht 7 und die elektrisch leitfähige Schicht 8 von dem Metallkern 6 entfernt, beispielsweise durch Fräsen oder eine Laserbearbeitung. Der Chipträger 1 ist also über die Lötverbindung 12, die vorzugsweise ein Metall oder eine Metalllegierung enthält und somit eine vergleichsweise gute Wärmeleitfähigkeit aufweist, direkt mit dem Metallkern 6 verbunden. Der Wärmewiderstand zwischen dem Chipträger 1 und dem Metallkern der Metallkernplatine 6 ist somit vorteilhaft gering. Insbesondere kann die von den Halbleiterchips 4 erzeugte Wärme über die Lötverbindung 12 besser an den Metallkern 6 der Metallkernplatine 5 abgeführt werden als über die Lötverbindungen 10, mit denen der Chipträger 1 zur Herstellung der elektrischen Kontakte mit der elektrisch leitfähigen Schicht 8 auf der Metallkernplatine 5 verbunden ist. Dies ist insbesondere dadurch begründet, dass die elektrisch leitfähige Schicht 8 durch die dielektrische Schicht 7, die in der Regel eine geringere thermische Leitfähigkeit als eine Lotschicht aufweist, von dem Metallkern 6 der Metallkernplatine 5 beabstandet ist.

Um die von den optoelektronischen Halbleiterchips 4 erzeugte Wärme besonders gut von dem Chipträger 1 an den Metallkern 6 der Metallkernplatine 5 abzuführen, weist der Chipträger 1 an der der Metallkernplatine 5 zugewandten zweiten Hauptfläche 3 vorzugsweise eine Erhöhung 9 auf. Durch die Erhöhung 9 wird ein Abstand zwischen dem Chipträger 1 und dem Metallkern 6 der Metallkernplatine 5, der ansonsten durch die Summe der Dicken der dielektrischen Schicht 7, der elektrisch leitfähigen Schicht 8, der Lotschichten 10 und der Kontaktschichten 11 gegeben ist, in dem Bereich der Lötverbindung 12 vorteilhaft vermindert.

Die Höhe der Erhöhung 9 ist vorteilhaft an die Summe der Dicken der dielektrischen Schicht 7 und der elektrisch leitfähigen Schicht 8 angepasst. Bevorzugt stimmt die Höhe der Erhöhung 9 mit der Summe der Dicken der dielektrischen Schicht 7 und der elektrisch leitfähigen Schicht 8 überein.

Beispielsweise kann die dielektrische Schicht 7 eine Dicke von etwa 70 µm aufweisen. Bei der elektrisch leitfähigen Schicht 8 kann es sich beispielsweise um eine etwa 30 µm dicke Schicht, insbesondere um eine Kupfer-Schicht, handeln. Die Summe der Dicken der dielektrischen Schicht 7 und der elektrisch leitfähigen Schicht 8 beträgt bei diesem Beispiel also 100 µm. In diesem Fall ist es vorteilhaft, wenn die Höhe der Erhöhung 9 etwa 100 µm beträgt.

Die Erhöhung des Chipträgers 1 im Bereich der Lötverbindung 12 hat den Vorteil, dass die Verbindung des Chipträgers 1 mit der elektrisch leitfähigen Schicht 8 durch Lotschichten 10 erfolgen kann, die in etwa die gleiche Dicke wie die Lötverbindung 12 aufweisen, die die thermische Verbindung des Chipträgers 1 mit dem Metallkern 6 der Metallkernplatine 5 herstellt.

Die Erhöhung 9 des Chipträgers 1 weist bevorzugt eine Dicke zwischen einschließlich 50 µm und einschließlich 200 µm auf.

Aufgrund der verbesserten Wärmeabfuhr von dem optoelektronischen Halbleiterchip 4 zu dem Metallkern 6 der Metallkernplatine 5 ist die Erfindung insbesondere für alle optoelektronischen Hochleistungs-Bauelemente vorteilhaft, also insbesondere für LED-Arrays mit einer Vielzahl von LEDs, oder für Anordnungen aus einem oder mehreren Halbleiterlasern auf einem gemeinsamen Chipträger 1.

Das in Figur 2 dargestellte Ausführungsbeispiel unterscheidet sich von dem in Figur 1 dargestellten Ausführungsbeispiel dadurch, dass nicht der Chipträger 1, sondern die Metallkernplatine 5 die Erhöhung 9 aufweist.

Die Erhöhung 9 kann beispielsweise galvanisch auf den Metallkern 6 aufgebracht sein. Alternativ ist es auch möglich, die Erhöhung 9 durch Prägen zu erzeugen. Weiterhin ist es auch möglich, die Erhöhung 9 des Metallkerns 6 dadurch zu erzeugen, dass seitlich von der Erhöhung angeordnete Bereiche des Metallkerns 6 abgetragen werden, zum Beispiel durch Fräsen. Die isolierende Schicht 7 und die elektrisch leitfähige Schicht 8 werden in diesem Fall nachfolgend aufgebracht, vorzugsweise als Stanzlaminat.

Ansonsten entspricht das zweite Ausführungsbeispiel, insbesondere hinsichtlich der vorteilhaften Ausgestaltungen, dem ersten Ausführungsbeispiel.

## Patentansprüche

1. Optoelektronisches Bauelement mit
- einer Metallkernplatine (5), die einen Metallkern (6), eine auf den Metallkern (6) aufgebrachte dielektrische Schicht (7) und eine auf die dielektrische Schicht (7) aufgebrachte elektrisch leitfähige Schicht (8) aufweist, und
- einem Chipträger (1), der mit der Metallkernplatine (5) verbunden ist, wobei der Chipträger (1) eine erste Hauptfläche (2), auf der mindestens ein optoelektronischer Halbleiterchip (4) angeordnet ist, und eine zweite Hauptfläche (3), die der Metallkernplatine (5) zugewandt ist, aufweist, wobei
der Chipträger (1) an der zweiten Hauptfläche (3) mittels einer Lötverbindung (12) mit dem Metallkern (6) der Metallkernplatine (5) verbunden ist, wobei die dielektrische Schicht (7) und die elektrisch leitfähige Schicht (8) im Bereich der Lötverbindung (12) von dem Metallkern (6) entfernt sind, **dadurch gekennzeichnet, dass**
der Chipträger (1) an der zweiten Hauptfläche (3) in dem Bereich der Lötverbindung (12) eine der Metallkernplatine zugewandte Erhöhung (9) aufweist, oder der Metallkern (6) der Metallkernplatine (5) in dem Bereich der Lötverbindung (12) eine dem Chipträger (1) zugewandte Erhöhung (9) aufweist.

2. Optoelektronisches Bauelement nach Anspruch 1,
**dadurch gekennzeichnet, dass**
die Erhöhung (9) eine Höhe zwischen einschließlich 50 µm und einschließlich 200 µm aufweist.

3. Optoelektronisches Bauelement nach einem der Ansprüche 1 oder 2,
**dadurch gekennzeichnet, dass**
eine Summe der Dicken der dielektrischen Schicht (7) und der elektrisch leitfähigen Schicht (8) im Wesentlichen mit der Höhe der Erhöhung (9) übereinstimmt.

4. Optoelektronisches Bauelement nach einem der vorhergehenden Ansprüche,
**dadurch gekennzeichnet, dass**
der Metallkern (6) der Metallkernplatine (5) Kupfer enthält.

5. Optoelektronisches Bauelement nach einem der vorhergehenden Ansprüche,
**dadurch gekennzeichnet, dass**
das Material des Chipträgers (1) eine Keramik ist.

6. Optoelektronisches Bauelement nach Anspruch 5,
**dadurch gekennzeichnet, dass**
die Keramik Aluminiumnitrid enthält.

7. Optoelektronisches Bauelement nach einem der vorhergehenden Ansprüche,
**dadurch gekennzeichnet, dass**
der Chipträger (1) an der zweiten Hauptfläche (3) Kontakte (11) zur elektrischen Kontaktierung des mindestens einen optoelektronischen Halbleiterchips (4) aufweist.

8. Optoelektronisches Bauelement nach Anspruch 7,
**dadurch gekennzeichnet, dass**
die Kontakte (11) mittels weiterer Lötverbindungen (10) mit der elektrisch leitfähigen Schicht (8) verbunden sind.

9. Optoelektronisches Bauelement nach Anspruch 7 oder 8,
**dadurch gekennzeichnet, dass**
die Kontakte (11) eine Dicke aufweisen, die geringer als die Höhe der Erhöhung (9) ist.

10. Optoelektronisches Bauelement nach einem der vorhergehenden Ansprüche,
**dadurch gekennzeichnet, dass**
der mindestens eine optoelektronische Halbleiterchip (4) elektrisch potentialfrei und thermisch leitend mit dem Metallkern (6) verbunden ist.

11. Optoelektronisches Bauelement nach einem der vorhergehenden Ansprüche,
**dadurch gekennzeichnet, dass**
auf dem Chipträger (1) mehrere optoelektronische Halbleiterchips (4) angeordnet sind.

12. Optoelektronisches Bauelement nach einem der vorhergehenden Ansprüche,
**dadurch gekennzeichnet, dass**
der mindestens eine optoelektronische Halbleiterchip (4) ein LED-Chip ist.

13. Optoelektronisches Bauelement nach einem der vorhergehenden Ansprüche,
**dadurch gekennzeichnet, dass**
der mindestens eine LED-Chip (4) eine Leistung von 0,2 W oder mehr aufweist.

## Claims

1. Optoelectronic component comprising
- a metal-core circuit board (5), which has a metal core (6), a dielectric layer (7) applied to the metal core (6), and an electrically conductive layer (8) applied to the dielectric layer (7), and
- a chip carrier (1), which is connected to the metal-core circuit board (5), wherein the chip carrier (1) has a first main surface (2), on which at least one optoelectronic semiconductor chip (4) is arranged, and a second main surface (3), which faces the metal-core circuit board (5),
wherein the chip carrier (1) is connected to the metal core (6) of the metal-core circuit board (5) at the second main surface (3) by means of a soldering connection (12), wherein the dielectric layer (7) and the electrically conductive layer (8) are removed from the metal core (6) in the region of the soldering connection (12),
**characterized in that**
the chip carrier (1) has at the second main surface (3), in the region of the soldering connection (12), an elevation (9) facing the metal-core circuit board, or the metal core (6) of the metal-core circuit board (5) has, in the region of the soldering connection (12), an elevation (9) facing the chip carrier (1).

2. Optoelectronic component according to Claim 1,
**characterized in that**
the elevation (9) has a height of between 50 µm and 200 µm inclusive.

3. Optoelectronic component according to either of Claims 1 and 2,
**characterized in that**
a sum of the thicknesses of the dielectric layer (7) and of the electrically conductive layer (8) substantially corresponds to the height of the elevation (9).

4. Optoelectronic component according to any of the preceding claims,
**characterized in that**
the metal core (6) of the metal-core circuit board (5) contains copper.

5. Optoelectronic component according to any of the preceding claims,
**characterized in that**
the material of the chip carrier (1) is a ceramic.

6. Optoelectronic component according to Claim 5,
**characterized in that**
the ceramic contains aluminium nitride.

7. Optoelectronic component according to any of the preceding claims,
**characterized in that**
the chip carrier (1) has, at the second main surface (3), contacts (11) for the electrical contacting of the at least one optoelectronic semiconductor chip (4).

8. Optoelectronic component according to Claim 7,
**characterized in that**
the contacts (11) are connected to the electrically conductive layer (8) by means of further soldering connections (10).

9. Optoelectronic component according to Claim 7 or 8,
**characterized in that**
the contacts (11) have a thickness that is smaller than the height of the elevation (9).

10. Optoelectronic component according to any of the preceding claims,
**characterized in that**
the at least one optoelectronic semiconductor chip (4) is connected to the metal core (6) in an electrically floating and thermally conductive fashion.

11. Optoelectronic component according to any of the preceding claims,
**characterized in that**
a plurality of optoelectronic semiconductor chips (4) are arranged on the chip carrier (1).

12. Optoelectronic component according to any of the preceding claims,
**characterized in that**
the at least one optoelectronic semiconductor chip (4) is an LED chip.

13. Optoelectronic component according to any of the preceding claims,
**characterized in that**
the at least one LED chip (4) has a power of 0.2 W or more.

## Revendications

1. Composant optoélectronique comprenant :
- une platine à noyau métallique (5), qui présente un noyau métallique (6), une couche diélectrique (7) appliquée sur le noyau métallique (6) et une couche électriquement conductrice (8) appliquée sur la couche diélectrique (7), et
- un support de puce (1) qui est relié à la platine à noyau métallique (5), dans lequel le support de puce (1) présente une première surface principale (2) sur laquelle est disposée au moins une puce à semi-conducteur optoélectronique (4), et une seconde surface principale (3) qui est tournée vers la platine à noyau métallique (5),
dans lequel le support de puce (1) est relié au noyau métallique (6) de la platine à noyau métallique (5) au niveau de la seconde surface (3) au moyen d'une liaison soudée (12), dans lequel la couche diélectrique (7) et la couche électriquement conductrice (8) sont enlevées du noyau métallique (6) dans la région de la liaison soudée (12),
**caractérisé en ce que** le support de puce (1) présente une surélévation (9) tournée vers la platine à noyau métallique au niveau de la seconde surface principale (3) dans la région de la liaison soudée (12), ou le noyau métallique (6) de la platine à noyau métallique (5) présente une surélévation (9) tournée vers le support de puce (1) dans la région de la liaison soudée (12).

2. Composant optoélectronique selon la revendication 1, **caractérisé en ce que** la surélévation (9) présente une hauteur comprise entre 50 µm inclus et 200 µm inclus.

3. Composant optoélectronique selon l'une quelconque des revendications 1 ou 2,
**caractérisé en ce qu'**une somme des épaisseurs de la couche diélectrique (7) et de la couche électriquement conductrice (8) correspond sensiblement à la hauteur de la surélévation (9).

4. Composant optoélectronique selon l'une quelconque des revendications précédentes,
**caractérisé en ce que** le noyau métallique (6) de la platine à noyau métallique (5) contient du cuivre.

5. Composant optoélectronique selon l'une quelconque des revendications précédentes,
**caractérisé en ce que** le matériau du support de puce (1) est une céramique.

6. Composant optoélectronique selon la revendication 5,
**caractérisé en ce que** la céramique contient du nitrure d'aluminium.

7. Composant optoélectronique selon l'une quelconque des revendications précédentes,
**caractérisé en ce que** le support de puce (1) présente des contacts (11) destinés à être en contact électrique avec l'au moins une puce à semi-conducteur optoélectronique (4) au niveau de la seconde surface (3).

8. Composant optoélectronique selon la revendication 7,
**caractérisé en ce que** les contacts (11) sont reliés à la couche électriquement conductrice (8) au moyen d'autres liaisons soudées (10).

9. Composant optoélectronique selon la revendication 7 ou 8,
**caractérisé en ce que** les contacts (11) présentent une épaisseur qui est inférieure à la hauteur de la surélévation (9).

10. Composant optoélectronique selon l'une quelconque des revendications précédentes,
**caractérisé en ce que** ladite au moins une puce à semi-conducteur optoélectronique (4) est reliée en l'absence de potentiel électrique et de manière thermiquement conductrice au noyau métallique (6).

11. Composant optoélectronique selon l'une quelconque des revendications précédentes,
**caractérisé en ce que** plusieurs puces à semi-conducteur optoélectroniques (4) sont disposées sur le support de puce (1).

12. Composant optoélectronique selon l'une quelconque des revendications précédentes,
**caractérisé en ce que** ladite au moins une puce à semi-conducteur optoélectronique (4) est une puce de LED.

13. Composant optoélectronique selon l'une quelconque des revendications précédentes,
**caractérisé en ce que** ladite au moins une puce de LED (4) présente une puissance de 0,2 W ou plus.
